# FASCICULE DE BREVET EUROPEEN

(11) **EP 1 046 021 B1**
(45) Date de publication et mention de la délivrance du brevet: **06.04.2005**
(21) Numéro de dépôt: 99900490.6
(22) Date de dépôt: 04.01.1999
(51) Int. Cl.: G01D 5/16, G01B 7/30, G01R 33/09

(54) **CAPTEUR ANGULAIRE LINEAIRE A MAGNETORESISTANCES**
LINEARER WINKELPOSITIONSSENSOR MIT MAGNETFELDABHÄNGIGEN WIDERSTÄNDEN
LINEAR ANGULAR SENSOR WITH MAGNETORESISTORS

(30) Priorité: 05.01.1998 FR 9800018
(43) Date de publication de la demande: 25.10.2000
(73) Titulaire: COMMISSARIAT A L'ENERGIE ATOMIQUE, 75015 Paris (FR)
(72) Inventeur: VIEUX-ROCHAZ, Line, F-38360 Sassenage (FR); VAUDAINE, Marie-Hélène, F-38180 Seyssins (FR); CUCHET, Robert, F-38000 Grenoble (FR); BRAISAZ, Thierry, F-38120 Saint Egrève (FR)
(74) Mandataire: Poulin, Gérard
(86) Numéro de dépôt international: PCT/FR1999/000001
(87) Numéro de publication internationale: WO 1999/035469

(56) Documents cités:
- DE-A- 19 536 433
- DE-A- 19 614 460
- DE-C- 19 532 674
- US-A- 5 629 620

## Description

### Domaine technique

La présente invention a pour objet un capteur de position angulaire linéaire à magnétorésistances. Elle trouve une application générale dans la mesure de l'orientation d'un champ magnétique et, plus particulièrement, dans la détection de la position angulaire d'un objet équipé d'une source de champ magnétique. Le capteur de l'invention possède un plan de mesure et il délivre un signal qui est lié sans équivoque à l'angle que la composante du champ dans ce plan fait avec une direction de référence située également dans ce plan. Tout objet peut être repéré dans sa position angulaire par un capteur conforme à l'invention : pièce, moteur, rotor, antenne, bouton de commande, etc...

### Etat de la technique antérieure

On connaît des dispositifs de détection de l'orientation d'un champ magnétique utilisant des matériaux magnétorésistifs à base de métaux de transition ferromagnétiques comme le nickel, le fer, le cobalt ou leurs alliages. Ces matériaux, mis sous forme de barreaux, permettent de construire des dispositifs délivrant des signaux sensiblement sinusoïdaux en fonction de l'orientation du champ appliqué. Ces dispositifs présentent l'inconvénient de nécessiter des moyens de traitement électroniques pour obtenir un signal de mesure fonction linéaire de l'angle.

On connaît également des capteurs utilisant, comme matériau magnétorésistif, des empilements de couches conduisant à un effet dit "géant" (en anglais "Giant Magnetoresistance Effect") ou GMR en abrégé. Ces empilements sont en général constitués de deux couches minces magnétiques séparées par une couche mince non magnétique et électriquement conductrice. De telles structures, dites aussi à vanne de spin (en anglais "spin valves"), sont décrites dans le document US-A-4,949,039. Un dispositif pour détecter la position angulaire d'un objet utilisant de telles magnétorésistances à effet géant est décrit dans le document US-A-5,650,721 et dans l'article de W. CLEMENS et al. intitulé "Contactless potentiometer based on giant magnetoresistance sensors", publié dans Jour. Appl. Phys. 81, (8), 15 April 1997, pp. 4310-4312. Dans cette technique, on utilise une magnétorésistance à vanne de spin ou éventuellement deux disposées à angle droit. Le signal délivré par chaque magnétorésistance est sensiblement sinusoïdal en fonction de l'angle du champ par rapport à une direction de référence. Mais il ne l'est pas rigoureusement en raison d'effets liés aux champs démagnétisants. De plus, il existe une hystérésis rotationnelle de 2° qui limite la résolution de l'appareil. On ne peut, par ailleurs, traiter des champs qui ne seraient pas compris entre 4,4 kA/m et 27,2 kA/m.

On connaît également des capteurs utilisant des matériaux à effet magnétorésistif géant et à réponse isotrope. On rappelle qu'un matériau magnétorésistif isotrope est un matériau dont la résistance varie en fonction de l'amplitude du champ mais ne varie pas en fonction de la direction du champ dans le plan : la réponse est la même quel que soit l'angle.

Pour qu'un détecteur d'angle, constitué de deux magnétorésistances montées à 90°, en demi-pont, donne une réponse fonction de l'angle formé par le champ et une direction de référence dans le plan, il faut que la réponse sous champ de chacune de ces magnétorésistances soit différente, afin de créer un déséquilibre du pont.

Dans le cas d'un matériau à effet géant isotrope, de façon générale, les deux magnétorésistances dont les dimensions sont définies par gravure, donneront la même réponse isotrope et il n'y aura pas d'effet de détection d'angle. Une solution pour réaliser, avec un matériau à effet géant isotrope, un détecteur d'angle à partir de deux magnétorésistances à 90° un demi pont a été donnée dans le brevet DE 195 32674. Pour que la réponse des deux magnétorésistances soit différente, le document propose de disposer des guides de flux magnétique autour des magnétorésistances dont la fonction est différente suivant que l'on considère l'une ou l'autre des magnétorésistances. Si, par exemple, le champ magnétique appliqué est parallèle à l'une des magnétorésistances, il est donc perpendiculaire à l'autre et les guides de flux captent la totalité des lignes de flux créées par le champ et qui auraient dû aller dans la première magnétorésistance. Celle-ci ne voit donc pas de champ, et sa variation de résistance est nulle. Mais ces mêmes guides, à l'inverse, concentrent tout le flux dans la seconde magnétorésistance qui voit donc le champ et sa résistance diminuer.

Le pont est bien déséquilibré et le capteur délivre une réponse.

La présente invention propose d'éviter ces guides de flux, tout en veillant à ce que les deux magnétorésistances donnent des réponses différentes.

Les documents DE-A-19 536 433 et DE-A-19 614 460 décrivent des dispositifs à magnétorésistances mais qui ne sont pas montés à angle droit.

### Exposé de l'invention

La présente invention propose de donner aux magnétorésistances une anisotropie de forme pour leur conférer une réponse anisotrope en fonction du champ (alors que le matériau est intrinsèquement isotrope). Cette anisotropie de forme peut être obtenue par gravure avec des dimensions appropriées. Par ailleurs, l'invention prévoit un montage particulier, à savoir en pont avec prélèvement du signal de lecture au point milieu du pont. De manière surprenante le signal obtenu est linéaire sur une très grande plage angulaire (à mieux que 5% sur 90°). Il n'est plus besoin alors d'utiliser une électronique de traitement du signal pour linéariser le signal de lecture. Par ailleurs, l'hystérésis a disparu. Enfin, dans un montage selon l'invention, il n'est plus besoin d'utiliser de polarisation des magnétorésistances.

De façon précise, la présente invention a pour objet un capteur angulaire comprenant au moins deux magnétorésistances en un matériau à effet magnétorésistif géant et à réponse isotrope, ces magnétorésistances étant disposées à angle droit, caractérisé par le fait que les deux magnétorésistances présentent une anisotropie de forme conduisant à une réponse sous champ magnétique anisotrope, les deux magnétorésistances étant connectées en série et formant un pont avec deux extrémités et un point milieu, des moyens d'alimentation étant connectés aux extrémités du pont et des moyens de mesure du déséquilibre du pont étant connectés au point milieu du pont.

Dans un mode de réalisation avantageux, l'invention combine deux ponts de ce type pour former un pont de Wheatstone à quatre magnétorésistances.

La linéarité du capteur peut encore être améliorée par l'ajout d'une résistance en matériau magnétorésistif disposée soit en série avec l'entrée du pont soit en parallèle sur la sortie de celui-ci.

De façon avantageuse les magnétorésistances sont réalisées à partir d'un empilement de couches à base de FeNi/Ag. Bien entendu d'autres empilements peuvent être utilisés et en particulier les empilements à base de Fe/Cr ou Fe/Cu ou NiFe/Cu.

### Brève description des dessins

- la figure 1 montre schématiquement un dispositif selon l'invention à deux magnétorésistances en pont ;
- la figure 2 montre la réponse d'un tel dispositif ;
- la figure 3 montre schématiquement un capteur à deux ponts, c'est-à-dire à quatre magnétorésistances ;
- la figure 4 montre la réponse de ce capteur ;
- la figure 5 montre la même réponse mais agrandie entre -45° et 45° ;
- la figure 6 illustre un mode de réalisation d'un dispositif selon l'invention dans une configuration en pont de Wheatstone à quatre magnétorésistances ;
- la figure 7 montre une variante avantageuse à résistance stabilisatrice en série ;
- la figure 8 montre une autre variante à résistance stabilisatrice en parallèle.

### Exposé détaillé de modes de réalisation

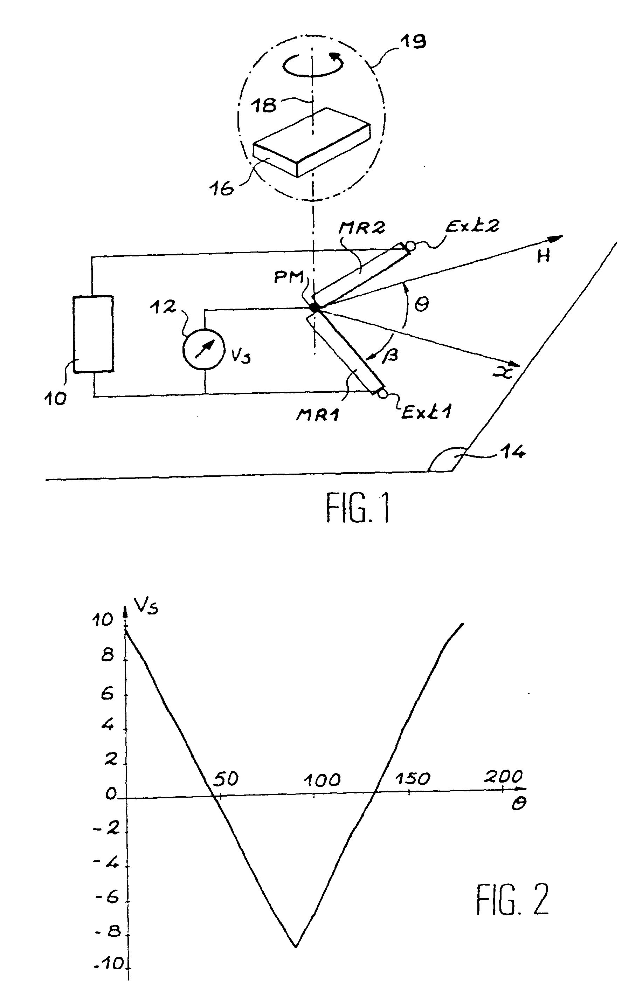

On voit, sur la figure 1, deux magnétorésistances MR1, MR2 à effet géant (ou encore du type à vanne de spin) disposées à angle droit. Ces deux magnétorésistances sont reliées en série et forment un pont résistif avec deux extrémités Ext1, Ext2 et un point milieu PM, qui est le point de connexion des magnétorésistances. Un moyen d'alimentation en tension 10 est relié aux extrémités du pont Ext1, Ext2 et un moyen de mesure 12 est prévu entre le point milieu PM et l'une des extrémités (Ext1 dans la variante illustrée).

La figure 1 montre les magnétorésistances en perspective. Elles définissent à elles deux un plan 14. Dans ce plan, on peut définir un axe de référence x passant par le point milieu PM. Cet axe fait un angle β avec la magnétorésistance MR1.

Par ailleurs, on suppose qu'un aimant permanent 16 est placé au-dessus du plan 14 et produit un champ magnétique dont la composante dans le plan 14 est notée H. Ce champ H fait un angle θ avec la direction de référence x. L'aimant 16 peut tourner autour de son axe 18. Cet aimant peut être fixé sur un objet 19 dont on veut suivre la position angulaire.

La figure 2 est une courbe expérimentale obtenue avec le capteur de la figure 1, dans le cas où les magnétorésistances sont constituées de deux couches minces magnétiques en FeNi séparées par une couche mince en argent. Cette courbe montre la tension de sortie Vs, prélevée au point milieu PM du pont, en fonction de l'angle θ que la composante H du champ fait avec la direction de référence. La courbe de la figure 2 n'est pas centrée sur l'origine, car, dans le cas illustré, l'angle β que fait l'axe de référence avec MR1 n'est pas égal à 45°. Lorsque c'est le cas, la plage de réponse s'étend de -90° à +90° et la plage linéaire va de -45° à 45°.

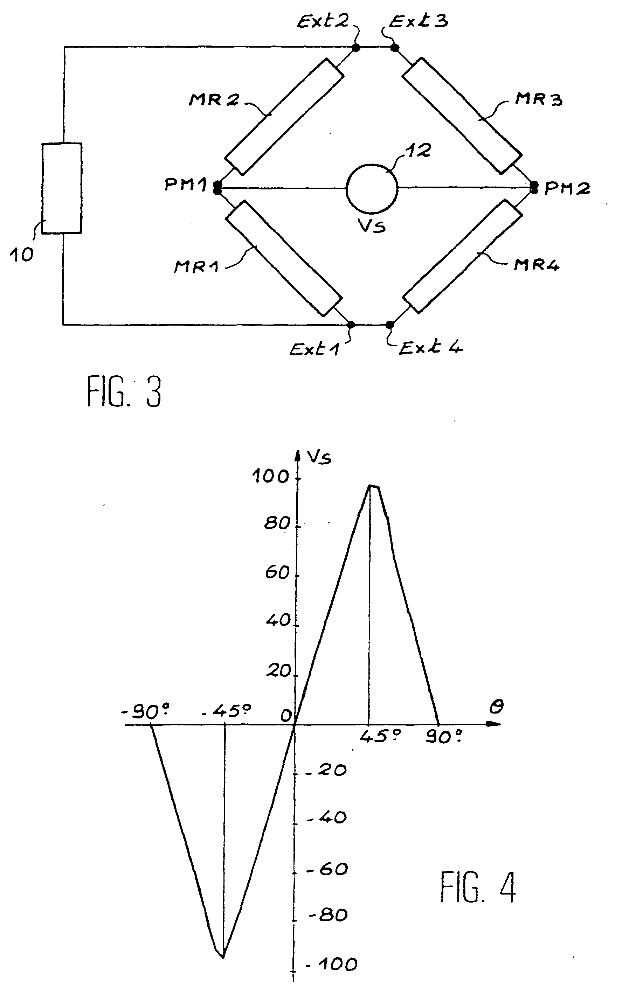

La figure 3 montre un capteur dans lequel on a combiné deux ponts du genre de celui de la figure 1. Ces ponts ont des extrémités respectivement Ext1, Ext2 et Ext3, Ext4 et deux points milieu respectivement PM1, PM2. Les extrémités Ext2, Ext3 sont reliées ensemble ainsi que les extrémités Ext1, Ext4. On obtient ainsi un pont de Wheatstone à quatre magnétorésistances. Le signal de lecture est toujours pris entre les points milieu et l'une des extrémités du pont, ce qui revient à prendre le signal entre les points milieu PM1 et PM2.

La figure 4 montre le signal de sortie Vs en fonction de l'angle θ. On voit que le signal est remarquablement linéaire de -45° à +45°. Ce montage présente l'avantage d'éliminer la composante continue en sortie du pont.

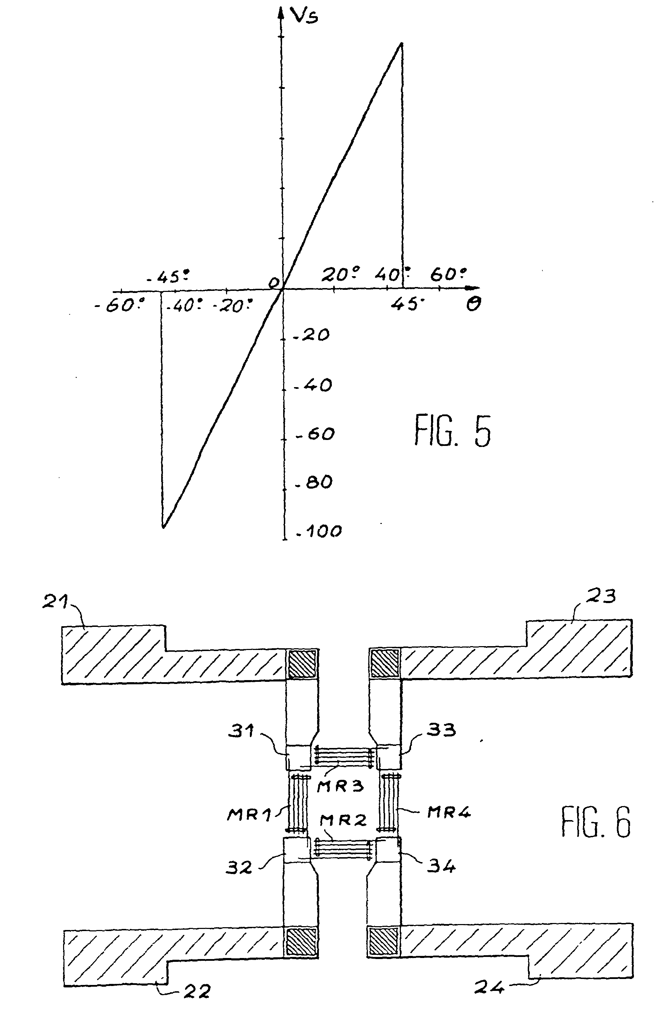

La figure 5 montre le même signal, mais de manière agrandie entre -45° et 45°, pour que la linéarité soit mieux appréciée. Si l'aimant est fixé sur un bouton de commande, le capteur en pont de Wheatstone des figures 3 et 4 délivrera un signal dont l'amplitude suivra linéairement la rotation du bouton.

La figure 6 illustre un mode de réalisation d'un capteur à quatre magnétorésistances FeNi/Ag disposées en carré, c'est-à-dire à 90° les unes des autres. Ces magnétorésistances portent encore les références MR1, MR2, MR3, MR4. Elles sont supposées être réalisées sous forme de ruban en méandres avec des bras repliés. Quatre plots extérieurs de prise de contact 21, 22, 23 et 24 sont reliés à quatre plots intérieurs 31, 32, 33 et 34. Le plot 32 constitue le point milieu pour le pont (MR1, MR2) et le plot 33 le point milieu pour le pont (MR3, MR4). C'est donc entre les plots extérieurs 22, 23 qu'on prélèvera le signal de mesure. Les plots 31 et 34 constituent les extrémités des ponts (MR1, MR2) et (MR3, MR4). C'est donc entre les plots extérieurs 21, 24 qu'on appliquera la tension d'alimentation.

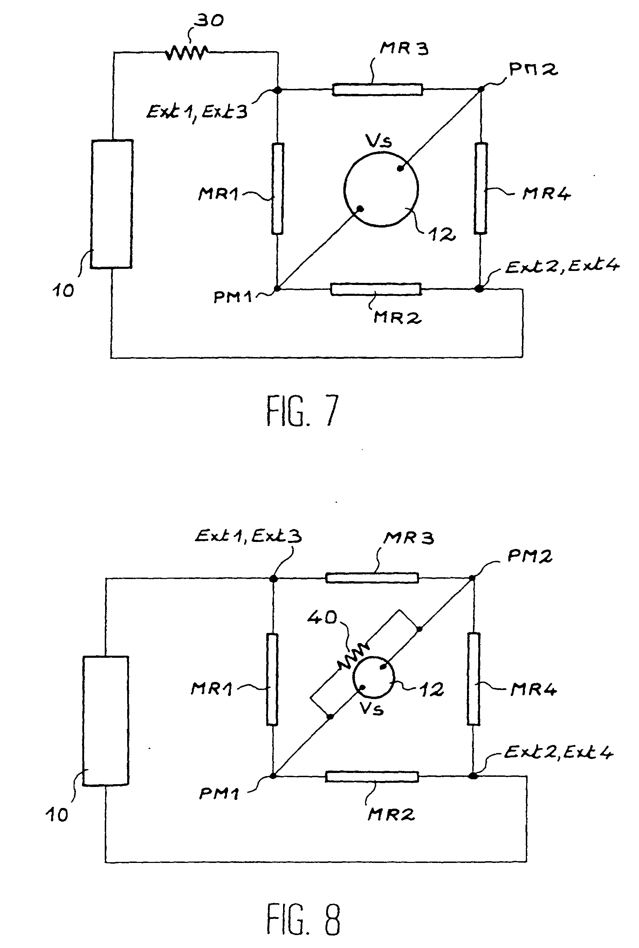

La linéarité du capteur de l'invention peut encore être améliorée par les perfectionnements illustrés sur les figures 7 et 8. Ces figures représentent un pont de Wheatstone à quatre magnétorésistances, avec les références déjà utilisées, et une résistance constituée en un matériau magnétorésistif de sensibilité au moins aussi grande que le matériau utilisé pour constituer les magnétorésistances du pont. Dans le cas de la figure 7, cette résistance 30 est placée en série dans l'entrée du pont, alors que, dans le cas de la figure 8, cette résistance 40 est placée en parallèle sur la sortie.

## Revendications

1. Capteur angulaire comprenant au moins deux magnétorésistances (MR1, MR2) en un matériau à effet magnétorésistif géant et à réponse isotrope, ces magnétorésistances étant disposées à angle droit, **caractérisé par le fait que** les deux magnétorésistances présentent une anisotropie de forme conduisant à une réponse sous champ magnétique anisotrope, les deux magnétorésistances (MR1, MR2) étant connectées en série et formant un pont avec deux extrémités (Ext1, Ext2) et un point milieu (PM), des moyens d'alimentation (10) étant connectés aux extrémités (Ext1, Ext2) du pont et des moyens (12) de mesure du déséquilibre du pont étant connectés au point milieu (PM) du pont.

2. Capteur angulaire comprenant deux capteurs selon la revendication 1 avec chacun deux magnétorésistances (MR1, MR2) (MR3, MR4), les extrémités (Ext1, Ext2) (Ext3, Ext4) des ponts de chaque capteur étant reliées entre elles deux à deux, les quatre magnétorésistances (MR1, MR2, MR3, MR4) formant ainsi un pont de Wheatstone, les moyens d'alimentation (12) alimentant ce pont de Wheatstone entre les extrémités reliées (Ext1, Ext3) (Ext2, Ext4), et les moyens de mesure (14) étant reliés entre les deux points milieu (PM1, PM2).

3. Capteur angulaire selon la revendication 2, dans lequel chaque magnétorésistance (MR1, MR2, MR3, MR4) présente une forme de ruban en méandre avec des bras repliés.

4. Capteur angulaire selon la revendication 2, dans lequel les quatre magnétorésistances (MR1, MR2, MR3, MR4) sont disposées en carré.

5. Capteur angulaire selon la revendication 4, comprenant quatre plots de connexions (31, 32, 33, 34) disposés aux quatre sommets du carré formé par les quatre magnétorésistances (MR1, MR2, MR3, MR4), chaque magnétorésistance étant connectée à ses extrémités à deux de ces plots.

6. Capteur angulaire selon la revendication 2, comprenant en outre au moins une résistance (30) en matériau magnétorésistif placée en série entre les moyens d'alimentation (10) et l'une des extrémités du pont (Ext1, Ext2), ce matériau magnétorésistif ayant une sensibilité au champ magnétique au moins aussi grande que celle des magnétorésistances (MR1, MR2, MR3, MR4) du pont.

7. Capteur angulaire selon la revendication 2, comprenant en outre une résistance (40) en matériau magnétorésistif disposée en parallèle sur les moyens de mesure (12), entre les deux points milieu (PM1, PM2), ce matériau magnétorésistif ayant une sensibilité au champ magnétique au moins aussi grande que celle des magnétorésistances (MR1, MR2, MR3, MR4) du pont.

8. Capteur angulaire selon la revendication 1, dans lequel les magnétorésistances sont réalisées à partir d'un empilement de couches à base de FeNi/Ag ou de Fe/Cr ou de Fe/Cu ou de NiFe/Cu.

9. Capteur angulaire selon la revendication 1, dans lequel l'anisotropie de forme est obtenue par gravure.

## Patentansprüche

1. Winkel positionssensor mit wenigstens zwei Magnetowiderständen (MR1, MR2) aus einem Material mit Riesen-Magnetoresistenzeffekt, wobei diese Magnetowiderstände rechtwinklig angeordnet sind,
**dadurch gekennzeichnet, dass** die beiden Magnetowiderstände eine Formanisotropie aufweisen, die unter einem Magnetfeld zu einem anisotropen Verhalten führt, wobei die beiden Magnetowiderstände (MR1, MR2) seriengeschaltet sind und eine Brücke mit zwei Enden (Ext1, Ext2) und einem Mittelpunkt (PM) bilden, Versorgungseinrichtungen (10) mit den Enden (Ext1, Ext2) der Brücke verbunden sind, und Messeinrichtungen (12) der Unsymmetrie der Brücke mit dem Mittelpunkt der Brücke (PM) verbunden sind.

2. Winkelpositionssensor mit zwei Sensoren nach Anspruch 1, jeder zwei Magnetowiderstände (MR1, MR2) (MR3, MR4) umfassend, wobei die Enden (Ext1, Ext2) (Ext3, Ext4) der Brücken jedes Sensors paarweise miteinander verbunden sind, die vier Magnetowiderstände (MR1, MR2, MR3, MR4) also eine Wheatstone-Brücke bilden, die Versorgungseinrichtungen (12) diese Wheatstone-Brücke zwischen den verbundenen Enden (Ext1, Ext3) (Ext2, Ext4) versorgen, und die Messeinrichtungen (14) zwischen den beiden Mittelpunkten (PM1, PM2) angeschlossen sind.

3. Winkelpositionssensor nach Anspruch 2, bei dem jeder Magnetowiderstand (MR1, MR2, MR3, MR4) die Form eines mäanderartigen Streifens aufweist, mit gebogenen bzw. zusammengefalteten Armen.

4. Winkelpositionssensor nach Anspruch 2, bei dem die vier Magnetowiderstände (MR1, MR2, MR3, MR4) quadratisch angeordnet sind.

5. Winkelpositionssensor nach Anspruch 4, vier Verbindungsstellen (31, 32, 33, 34) umfassend, angeordnet an den Ecken des durch die vier Magnetowiderstände (MR1, MR2, MR3, MR4) gebildeten Quadrats, wobei jeder Magnetowiderstand mit seinen Enden an zwei dieser Verbindungsstellen angeschlossen ist.

6. Winkelpositionssensor nach Anspruch 2, außerdem wenigstens einen Widerstand (30) aus magnetoresistivem Material umfassend, seriengeschaltet zwischen den Versorgungseinrichtungen (10) und einem der Enden der Brücke (Ext1, Ext2), wobei dieses magnetoresistive Material eine Empfindlichkeit für das Magnetfeld hat, die mindestens genauso groß ist wie die der Magnetowiderstände (MR1, MR2, MR3, MR4) der Brücke.

7. Winkelpositionssensor nach Anspruch 2, außerdem wenigstens einen Widerstand (40) aus magnetoresistivem Material umfassend, parallelgeschaltet zu den Messeinrichtungen (12), zwischen den beiden Mittelpunkten (PM1, PM2), wobei dieses magnetoresistive Material eine Empfindlichkeit für das Magnetfeld hat, die mindestens genauso groß ist wie die der Magnetowiderstände (MR1, MR2, MR3, MR4) der Brücke.

8. Winkelpositionssensor nach Anspruch 1, bei dem die Magnetowiderstände durch einem Stapel von Schichten auf der Basis von FeNi/Ag oder Fe/Cr oder Fe/Cu oder NiFe/Cu gebildet werden.

9. Winkelpositionssensor nach Anspruch 1, bei dem die Formanisotropie durch Ätzen realisiert wird.

## Claims

1. Angular sensor comprising at least two magnetoresistors (MR1, MR2) of a material with giant magnetoresistance effect and with isotropic response, these magnetoresistors being placed perpendicularly, **characterized by** the fact that the two magnetoresistors have anisotropy shape such that their response in a magnetic field is anisotropic, the two magnetoresistors (MR1, MR2) being connected in series and forming a bridge with two ends (Ext1, Ext2) and a midpoint (PM), the power supply means (10) being connected at the ends (Ext1, Ext2) of the bridge and means (12) of measuring the unbalance of the bridge being connected at the. midpoint (PM) of the bridge.

2. Angular sensor comprising two sensors according to claim 1 each with two magnetoresistors (MR1, MR2) (MR3, MR4), the ends (Ext1, Ext2) (Ext3, Ext4) of the bridges of each sensor being connected to each other in pairs, the four magnetoresistors (MR1, MR2, MR3, MR4) thus forming a Wheatstone bridge, the power supply means (12) powering this Wheatstone bridge between the connected ends (Ext1, Ext3) (Ext2, Ext4), and the measurement means (14) being connected between the two midpoints (PM1, PM2).

3. Angular sensor according to claim 2, in which each magnetoresistor (MR2, MR2, MR3, MR4) is in the form of a meandering tape with folded arms.

4. Angular sensor according to claim 2, in which the four magnetoresistors (MR1, MR2, MR3, MR4) are laid out in a square.

5. Angular sensor according to claim 4, comprising four connection pads (31, 32, 33, 34) arranged at the four corners of the square formed by the four magnetoresistors (MR1, MR2, MR3, MR4), each magnetoresistor being connected to two of these pads at its ends.

6. Angular sensor according to claim 2, also comprising at least one resistance (30) made of a magnetoresistive material placed in series between the power supply means (10) and one of the ends of the bridge (Ext1, Ext2), the sensitivity of this magnetoresistive material to the magnetic field being at least as good as the sensitivity of the magnetoresistors (MR1, MR2, MR3, MR4) of the bridge.

7. Angular sensor according to claim 2, also comprising a resistance (40) made of a magnetoresistive material placed in parallel on the measurement means (12) between the two midpoints (PM1, PM2), the sensitivity of this magnetoresistive material to the magnetic field being at least as good as the sensitivity of the magnetoresistors (MR1, MR2, MR3, MR4) in the bridge.

8. Angular sensor according to claim 1, in which the magnetoresistors are made from a stack of layers based on FeNi/Ag or Fe/Cr or Fe/CU or NiFe/Cu.

9. Angular sensor according to claim 1, in which anisotropy shape is achieved by etching.
